# EUROPÄISCHE PATENTANMELDUNG

(11) **EP 3 967 442 A1**
(43) Veröffentlichungstag der Anmeldung: **16.03.2022**
(21) Anmeldenummer: 21194589.4
(22) Anmeldetag: 05.03.2018
(51) Int. Cl.: B23K 26/402, B23K 26/00, C23C 14/12, C23C 14/04, B23K 26/53

(54) **VERFAHREN ZUR HERSTELLUNG EINER TECHNISCHEN MASKE**

(30) Priorität: 06.03.2017 DE 102017104656; 06.03.2017 DE 102017104657
(62) Teilanmeldung aus: 18708997.4
(71) Anmelder: LPKF Laser & Electronics AG, 30827 Garbsen (DE)
(72) Erfinder: OSTHOLT, Roman, 30855 Langenhagen (DE); AMBROSIUS, Norbert, 30827 Garbsen (DE); SCHNOOR, Arne, 30625 Hannover (DE); DUNKER, Daniel, 30419 Hannover (DE); HALE, Kevin, 31303 Burgdorf (DE); DÖRGE, Moritz, 31555 Suthfeld (DE); WENKE, Stephan, 31535 Neustadt a. Rbg. (DE)
(74) Vertreter: Scheffler, Jörg

(57) **Zusammenfassung**

Die Erfindung betrifft ein Verfahren zur Herstellung einer technischen Maske (1) aus einem plattenförmigen Substrat (2), beispielsweise aus Glas, Saphir oder Silizium. Zumindest eine Öffnung der Maske (1) wird mittels laserinduzierten Tiefenätzens hergestellt, wobei das Substrat (2) zumindest für die beim laserinduzierten Tiefenätzen eingesetzte Laserwellenlänge transparent ist. Hierzu wird das Substrat (2) zum Trennen von insbesondere geschlossenen Konturen (3) durch die Pulse des Lasers entlang von vordefinierten Bearbeitungslinien (4) modifiziert. Lokale Unterbrechungen der Bearbeitungslinien (4) in Form von Verbindungsstegen, den sogenannten Breakouttabs, gewährleisten, dass die zu trennenden Konturen (3) auch nach der Behandlung mit der Ätzlösung zunächst noch mit dem plattenförmigen Substrat (2) verbunden sind. Das auf diese Weise vorbehandelte plattenförmige Substrat (2) wird im folgenden Schritt mit einer Ätzlösung, wie beispielsweise Flusssäure (HF) oder Kaliumhydroxid (KOH), behandelt, wodurch die nicht modifizierten Bereiche des Substrates (2) homogen und isotrop geätzt werden. Die modifizierten Bereiche reagieren im Verhältnis zu unbehandelten Bereichen des Substrats (2) anisotrop, sodass sich an den behandelten Stellen zunächst gerichtete Vertiefungen ausbilden bis schließlich das Material des Substrats (2) an dieser Stelle vollständig aufgelöst ist.

## Beschreibung

Die Erfindung betrifft ein Verfahren zur Herstellung einer technischen Maske aus einem plattenförmigen Substrat.

Unter technischen Masken mit offenen Aperturen werden im Allgemeinen mehrfach verwendbare Einrichtungen zum strukturierten Materialauftrag oder Materialabtrag bezeichnet. Darunter fallen unter anderem Schablonen für den Schablonendruck oder Schattenmasken für Abscheideverfahren und Abtragsverfahren. Druckschablonen werden für den Schablonen- und den Siebdruck verwendet. Dabei werden z. B. lasergeschnittene Stahlfolien auf Rahmen gespannt. Zum Drucken wird eine Drucksubstanz mit einem Rakel durch die Öffnungen in der Schablone hindurch gedrückt.

Schattenmasken werden als Maskierung für Beschichtungsprozesse genutzt, beispielsweise für Sputter- oder Gasphasenbeschichtung. Schattenmasken werden häufig für die Herstellung von Displays (beispielsweise OLED-Displays) verwendet. Dabei weist die Maske für jeden Pixel beispielsweise 50 µm große, rechteckige Öffnungen auf.

Beim Laserinduzierten Tiefenätzen (z. B. WO 2014/161534 A2 und WO 2016/041544 A1) wird ein transparentes Material mittels eines Laserpulses oder einer Pulsfolge über einen länglichen Bereich entlang der Strahlachse, häufig über die gesamte Dicke des transparenten Materials, z. B. bei Glasplatten, modifiziert, sodass in einem anschließenden nasschemischen Ätzbad die Modifikation anisotrop geätzt wird.

Industriell werden technische Masken in der Regel aus sehr dünnem Edelstahl oder anderen Metallblechen hergestellt. Die für den strukturierten Materialauftrag bzw. -abtrag notwendigen Maskenöffnungen (Aperturen) werden mittels Laserschneiden bzw. photolithographischen Ätzverfahren eingebracht. Ein weiterer im Stand der Technik bekannter Weg zur Herstellung von technischen Masken ist das Elektroforming. Eine technische Maske ist in der Regel mit einer sehr hohen Anzahl an Aperturen versehen, die wiederum in Form, Position und Anzahl unter Umständen keinen Gesetzmäßigkeiten unterliegen sind. Die Aperturen sollen häufig Apektverhältnisse (Verhältnis von Materialdicke zu Strukturgröße) von > 1:1 aufweisen, wodurch alle isotropen Ätzverfahren ausscheiden. Während des eigentlichen Materialauftrags bzw. -abtrags müssen die sehr dünnen Masken sehr eben über oder auf dem zu bearbeitenden Material positioniert werden. Die im Stand der Technik eingesetzten dünnen Metallsubstrate werden dazu mit einer Zugspannung beaufschlagt, um Verformungen und Durchhängen zu vermeiden.

Glas weist als Material für technische Masken mit offenen Aperturen im Vergleich zu Metall einige grundsätzliche Vorteile auf. So besitzt Glas eine erhöhte Kratzfestigkeit, ein hohes E-Modul und eine geringere thermische Ausdehnung, es dehnt sich bei Belastung nicht plastisch und ist chemisch wesentlich beständiger. Die Transparenz des Glases lässt sich für optische Verfahren, z. B. zum Ausrichten, ausnutzen. Trotz der genannten Vorteile wird Glas nicht als Material für technische Masken für den strukturierten Materialauftrag bzw. -abtrag eingesetzt. Dies ist in erster Linie dem Vorurteil geschuldet, dass Glas zu bruchanfällig sei, um als Material für Masken mit offenen Aperturen eingesetzt zu werden. Insbesondere die Beaufschlagung mit einer Zugspannung, wie sie im Stand der Technik für Metallmasken üblich ist, gilt als sehr kritisch für die Zuverlässigkeit einer technischen Maske aus Glas.

Ein Verfahren, beim dem Strukturen in Glas durch Ätzen erzeugt werden und die Bruchfestigkeit daher ausreichend hoch ist, ist Lithographie. Dabei wird eine Beschichtung belichtet und anschließend lokal geöffnet. Anschließend wird das Substrat geätzt, um die gewünschten Strukturen zu erzeugen. Die Beschichtung dient dabei als Ätzresist. Da der Ätzangriff an den Stellen, an denen das Ätzresist geöffnet wurde, isotrop stattfindet, lassen sich damit aber keine Strukturen mit großem Aspektverhältnis erzeugen. Um hochauflösende Strukturen in technischen Masken herstellen zu können, werden Chrom-Nickel-Folien lithographisch strukturiert. Dafür werden Teilbereiche maskiert und die nicht maskierten Bereiche geätzt. Der Ätzprozess ist dabei isotrop, daher kommt es zu einem Unterätzen der Maskierung, wodurch der Durchmesser der erzeugten Strukturen unkontrolliert zunimmt. Diese Strukturen werden Ätzlippen genannt.

Der Erfindung liegt die Aufgabe zugrunde, eine Möglichkeit zu schaffen, ein wesentlich verbessertes Herstellungsverfahren für technische Masken aus Glas zu schaffen.

Diese Aufgabe wird erfindungsgemäß mit einem Verfahren gemäß den Merkmalen des Anspruches 1 gelöst. Die weitere Ausgestaltung der Erfindung ist den Unteransprüchen zu entnehmen.

Erfindungsgemäß wird eine technische Maske mittels laserinduziertem Tiefenätzen erzeugt. Dafür wird ein plattenförmiges Substrat, das für mindestens die Laserwellenlänge, die beim laserinduzierten Tiefenätzen verwendet wird, transparent ist, mit mindestens einer Öffnung versehen. Die mindestens eine Öffnung wird durch laserinduziertes Tiefenätzen derart hergestellt, dass das Substrat zunächst mit einem Laserstrahl entlang der Kontur der Öffnung modifiziert wird und anschließend in einem Ätzbad an den modifizierten Stellen anisotrop geätzt wird.

Erfindungsgemäß werden unter technischen Masken beispielsweise
mehrfach verwendbare Einrichtungen zum strukturierten Materialauftrag oder Materialabtrag verstanden.

Erfindungsgemäß lässt sich aufgrund des anisotropen Ätzangriffes ein gewünschter Kantenwinkel, insbesondere mit einem vorbestimmten Öffnungswinkel erreichen, was sich insbesondere bei der Verwendung der Glasschablone als Schattenmasken, beispielsweise für Sputterprozesse, als besonders vorteilhaft erweist.

Die Erfindung beruht auf der überraschenden Erkenntnis, dass Glassubstrate, in die Aperturen mittels laserinduzierten Tiefenätzen eingebracht wurden, sehr wohl als Material für den strukturierten Materialauftrag bzw. -abtrag eingesetzt werden können. Besonders überraschend ist dabei die Erkenntnis, dass ein derartig hergestelltes Glassubstrat sogar die im Stand der Technik übliche Beaufschlagung mit einer Zugspannung übersteht.

Mit dem erfindungsgemäßen Verfahren kann die Form der anisotrop geätzten Trennflächen oder Ausnehmungen sehr genau durch die Laserbestrahlung gesteuert und die Bildung von Ätzlippen vermieden werden.

In einem zweiten Prozessschritt erfolgt zumindest ein Ätzschritt, wobei das Fortschreiten, insbesondere die Geschwindigkeit des Ätzangriffes, beispielsweise durch Flusssäure von den spezifischen Eigenschaften der Modifikation abhängt. Der Ätzangriff kann auch zunächst auf eine Seite beschränkt werden, beispielsweise durch einseitiges Beschichten des Substrats mit einem Ätzresist..

In einem weiteren Ätzschritt können beispielsweise Radien an den Schnittkanten erzeugt werden.

Als Ätzmedien sind beispielsweise folgende nasschemische Lösungen realisierbar:
Flusssäure:
   - Konzentration: 1 - 20 %
   - Temperatur: 5 ― 40 °C
   - Zweite Säure: H2SO4, HCL, H3PO4
Kalilauge:
   - Konzentration: 10 - 60 %
   - Temperatur: 85 ― 160 °C

Im Gegensatz zu den Verfahren nach dem Stand der Technik, mit denen eine technische Maske aus Glas mit einer ausreichenden Bruchfestigkeit bisher nicht realisiert werden konnte, weil die Bearbeitung stets zu unvermeidlichen Mikrorissen führt und damit der Einsatz als Schablone, die zum Gebrauch in einen Rahmen eingespannt werden und großen mechanischen Belastungen beim Rakeln ausgesetzt sind, ausgeschlossen ist, werden solche Mikrorisse erfindungsgemäß vermieden.

Durch die Verwendung von Glas als Material für technische Masken können Prozesse zum Materialauftrag bzw. -abtrag zuverlässiger durchgeführt werden. Folgende weitere erfindungsgemäße Vorteile können so erreicht werden:
- höhere Genauigkeit (keine plastische Verformung)
- größere Härte, d. h. abrasionsbeständiger
- thermische Ausdehnung wie Silizium, Keramik
- größere chemische und mechanische Beständigkeit
- vereinfachte Ausrichtung durch optische Methoden aufgrund transparenter Eigenschaften

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig. 1: eine Draufsicht auf eine mit dem erfindungsgemäßen Verfahren hergestellte technische Maske;
- Fig. 2: einen Querschnitt durch ein erfindungsgemäß hergestellte Öffnung nach der Ätzbehandlung;
- Fig. 3: einen Querschnitt durch ein mit einem Verfahren nach dem Stand der Technik hergestellte Öffnung nach der Ätzbehandlung.

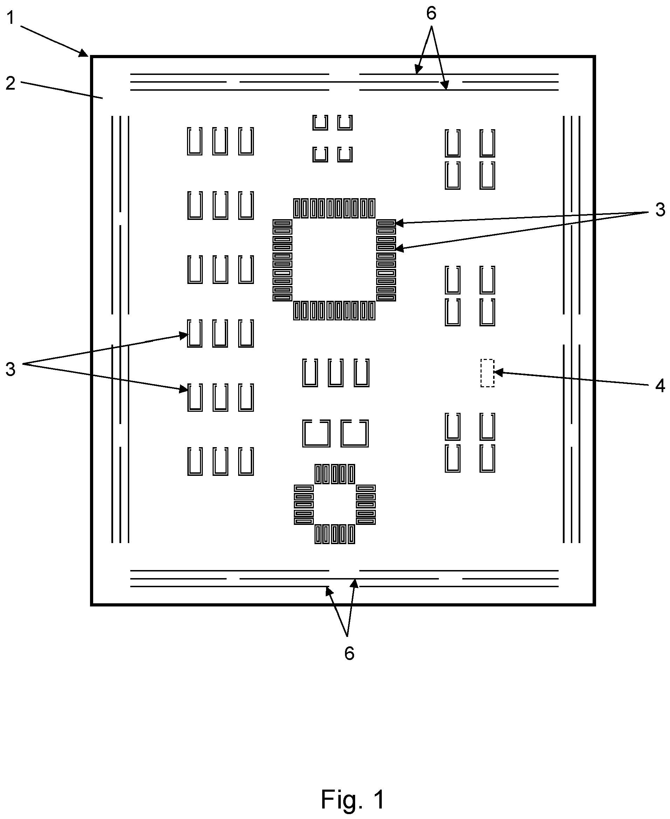

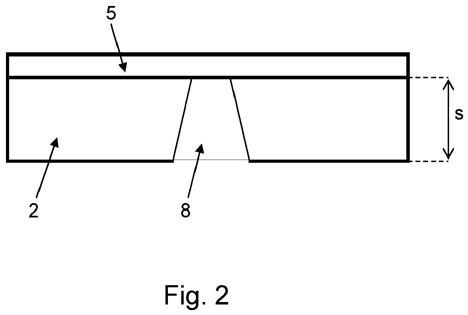

Das erfindungsgemäße Verfahren zur Herstellung einer technischen Maske 1 aus einem plattenförmigen Substrat 2 wird nachstehend anhand der Figuren 1 und 2 näher erläutert. Das plattenförmige Substrat 2 ist zumindest für die für das laserinduzierte Tiefenätzen eingesetzte Laserwellenlänge transparent. Es kann beispielsweise aus Glas, Saphir oder Silizium bestehen.

Das plattenförmige Substrat 2 mit einer Stärke s von wenigen hundert Mikrometern wird zum Trennen von insbesondere geschlossenen Konturen 3 mittels einer nicht gezeigten Laserstrahlung durch die Pulse des Lasers entlang von vordefinierten Bearbeitungslinien 4 modifiziert. Zum Schneiden der Konturen 3 wird darauf geachtet, dass die Pulse des Lasers entlang der vordefinierten Bearbeitungslinien 4 gesetzt werden und der Abstand zwischen den resultierenden Modifikationszentren nur wenige Mikrometer beträgt. Lokale Unterbrechungen der Bearbeitungslinien in Form von Verbindungsstegen, den sogenannten Breakouttabs, gewährleisten, dass die zu trennenden Konturen 3 auch nach der Behandlung mit der Ätzlösung zunächst noch mit dem plattenförmigen Substrat 2 verbunden sind.

Das auf diese Weise vorbehandelte plattenförmige Substrat 2 wird im folgenden Schritt mit einer Ätzlösung, wie beispielsweise Flusssäure (HF) oder Kaliumhydroxid (KOH), behandelt, wodurch die nicht modifizierten Bereiche des Glassbustrates 2 homogen und isotrop geätzt werden. Die modifizierten Bereiche reagieren im Verhältnis zu unbehandelten Bereichen des Substrats 2 anisotrop, sodass sich an den behandelten Stellen zunächst gerichtete Vertiefungen ausbilden bis schließlich das Material des Substrats 2 an dieser Stelle vollständig aufgelöst ist. Üblicherweise nimmt der Ätzschritt abhängig von dem verwendeten Substrat 2, dessen Stärke s sowie der Konzentration der Ätzlösung einige Minuten bis wenige Stunden in Anspruch.

Zu diesem Zeitpunkt wird das konturgeschnittene, durch Ausnehmungen 8 getrennte Layout ausschließlich von den Breakouttabs in dem restlichen plattenförmigen Substrats 2 gehalten, sodass nach dem Eintauchen in eine verdünnende oder neutralisierende Lösung sowie der anschließenden Trocknung die gewünschten Layouts aus dem verbliebenen Substrat 2 herausgetrennt werden können und dadurch die fertige technische Maske 1 entsteht.

Die Öffnungen können im Querschnitt einen Öffnungswinkel zu einer der Oberflächen von >5° bis zu >35° aufweisen. Dies kann das Beschichten mit Drucksubstanz, dass Ablösen von der zu bedruckenden Oberflächen oder den Beschichtungsprozess vereinfachen oder die Auflösung beim Materialauftrag oder -abtrag verbessern.

Darüber hinaus ist erfindungsgemäß auch das einseitige Ätzen des plattenförmigen Substrats 2 möglich, wenn eine Seite des Substrates 2 mit einem Ätzresist 5 geschützt wird, wie dies in Figur 2 dargestellt ist. Hierbei kommen beispielsweise Chromschichten oder Klebefolien zum Einsatz. Durch das einseitige Ätzen wird es möglich, Öffnungen mit verschiedenen Höhenprofilen im Querschnitt zu erzeugen.

Klebefolien lassen sich zusätzlich in Rahmen spannen, was insbesondere die Handhabung von Dünnglas mit einer Stärke s von weniger als 100 µm vereinfacht. Bei einer Stärke s des plattenförmigen Substrats 2 von weniger als 100 µm verhält sich das Substrat 2 ähnlich einer Kunststofffolie und kann daher im Ätzbecken nicht in einen konventionellen Halter fixiert werden.

Wird eine Chromschicht als Ätzresist 5 verwendet, so können die Konturen 3 auch vollständig ausgeschnitten werden. Sie bleiben dann an der Chromschicht haften und fallen nicht ins Ätzbecken. Beim Entfernen der Chromschicht, insbesondere in einem zweiten Ätzbad, werden die Ausschnitte ebenfalls entfernt und müssen nicht herausgebrochen werden.

Bei der Verwendung der technischen Maske 1 wird diese bevorzugt in einen Rahmen eingespannt. Der Rahmen ist dabei vorzugsweise mit einer Vorrichtung zum Spannen der Maske versehen. Beim Spannen wird die technische Maske 1 großen mechanischen Belastungen ausgesetzt. Diese können durch Entlastungsstrukturen 6 kompensiert werden, die geeignet sind, auftretende Zugspannungen durch Verformung abzubauen. Die mittels dieser Strukturen erreichbare Gesamtverformung ist deutlich größer ist als die Bruchdehnung des Materials, ohne dass die Bruchdehnung auch nur lokal überschritten wird. Solche Entlastungsstrukturen 6 können beispielsweise schlitzförmig im Randbereich des Substrats 2 erzeugt werden.

Die technische Maske kann zumindest lokal mit einer Metallschicht versehen werden. Die Metallschicht kann zum Beispiel verwendet werden, um die Maske magnetisch zu befestigen. Die Metallschicht macht zudem die Nutzung als optische Maske möglich.

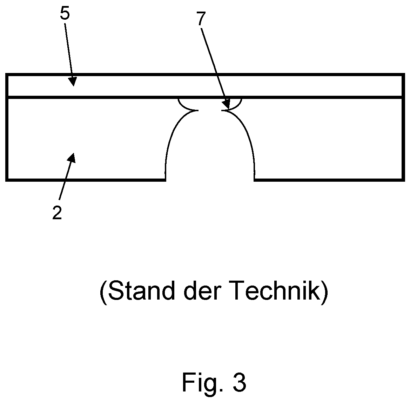

Zum besseren Verständnis verdeutlicht die Figur 3 eine Ätzbehandlung mit einem Verfahren nach dem Stand der Technik anhand eines Querschnittes durch ein so hergestelltes Substrat 2. Wie zu erkennen, entsteht dabei infolge punktueller Modifikationen mit gleichförmiger Ausbreitung und dem nachfolgenden isotropen Ätzabtrag eine sogenannte Ätzlippe 7 mit undefinierter Öffnungsweite. Da der Ätzprozess isotrop verläuft, d. h. die Ätzrate ist in alle Richtungen gleich ist, kommt es zu einem Unterätzen des Ätzresistes 5, wodurch der Durchmesser der erzeugten Strukturen unkontrolliert zunimmt. Dies kann erfindungsgemäß durch anisotropen Ätzabtrag verhindert werden.

Zum Verwenden der technischen Maske für Materialauftrags- oder Materialabtragsprozesse ist eine genaue Positionierung notwendig. Bei der Verwendung von transparenten Materialien als plattenförmiges Substrat ist eine optische Positionierung möglich, die z.B. anhand von Oberflächenstrukturen, Ausnehmungen oder lokalen Beschichtungen erfolgen kann.

### BEZUGSZEICHENLISTE

- 1: Maske
- 2: Substrat
- 3: Kontur
- 4: Bearbeitungslinie
- 5: Ätzresist

- 6: Entlastungsöffnung
- 7: Ätzlippe
- 8: Ausnehmung

- s: Stärke

## Patentansprüche

1. Verfahren zur Herstellung einer technischen Maske **gekennzeichnet dadurch, dass** die Maske mindestens aus einem plattenförmigen Substrat besteht und das plattenförmigen Substrat mindestens für eine Laserwellenlänge transparent ist und mindestens eine Öffnung der Maske mittels Laserinduzierten Tiefenätzens hergestellt wurde.

2. Verfahren nach Anspruch 1, **dadurch gekennzeichnet, dass** der Ätzangriff beim Laserinduzierten Tiefenätzen zumindest zeitweise einseitig stattfindet.

3. Verfahren nach einem der vorhergehenden Ansprüche, **dadurch gekennzeichnet, dass** das Material des plattenförmigen Substrats ausgewählt ist aus Glas, Silizium, Saphir.

4. Verfahren nach einem der vorhergehenden Ansprüche, **dadurch gekennzeichnet, dass** die Parameter bei der Lasermodifizierung oder beim Ätzangriff so gewählt werden, dass die Öffnungen der Maske einen Öffnungswinkel von >5°, bevorzugt >15°, besonders bevorzugt >25°, besonders bevorzugt >35° aufweisen.

5. Verfahren nach einem der vorhergehenden Ansprüche, **dadurch gekennzeichnet, dass** die Maske neben dem plattenförmigen Substratmaterial aus mindestens einer weiteren Komponente besteht.

6. Verfahren nach Anspruch 5, **dadurch gekennzeichnet, dass** diese zweite Komponente ein Rahmen ist.

7. Verfahren nach Anspruch 5 oder 6, **dadurch gekennzeichnet, dass** die zweite Komponente mit mindestens einer Vorrichtung zum Spannen des plattenförmigen Substratmaterials versehen ist.

8. Verfahren nach Anspruch 7, **dadurch gekennzeichnet, dass** das plattenförmige Substratmaterial zumindest partiell mit Dehnungsstrukturen versehen sind.

9. Verfahren nach zumindest einem der vorhergehenden Ansprüche, **dadurch gekennzeichnet, dass** insbesondere in den Randbereich des plattenförmigen Substrats (2) insbesondere schlitzförmige Entlastungsöffnungen (6) eingebracht werden.

10. Verfahren nach Anspruch 10, **dadurch gekennzeichnet, dass** die Entlastungsöffnungen (6) eine gestreckte oder spiralförmige Geometrie aufweisen.

11. Verfahren nach einem der vorhergehenden Ansprüche, **dadurch gekennzeichnet, dass** das plattenförmige Substrat eine Dicke von < 250 µm, bevorzugt < 150 µm, besonders bevorzugt < 75 µm, aufweist.

12. Verfahren nach einem der vorhergehenden Ansprüche, **dadurch gekennzeichnet, dass** das plattenförmige Substrat selektiv mit einer Ätzmaske versehen wird, wodurch der Ätzangriff zumindest lokal behindert wird, wodurch eine Maske mit Höhenprofil entsteht.

13. Verfahren nach einem der vorhergehenden Ansprüche, **dadurch gekennzeichnet, dass** die Maske zumindest partiell mit einer Metallschicht versehen wird.

14. Verfahren zum strukturierten Materialauftrag bzw. -abtrag mittels einer wiederverwendbaren Maske, **dadurch gekennzeichnet, dass** die Maske nach einem der vorangegangenen Ansprüche hergestellt wurde und die Maske relativ zu dem zu beschichtenden oder abzutragenden Material ausgerichtet wird.

15. Verfahren zum strukturierten Materialauf- bzw. -abtrag mittels einer wiederverwendbaren Maske nach Anspruch11, **dadurch gekennzeichnet, dass** die Ausrichtung anhand von Informationen erfolgt, die anhand von Oberflächenstrukturen, Ausnehmungen oder abgeschiedenen Schichten auf der Maske gewonnen werden.

16. Verfahren nach zumindest einem der vorhergehenden Ansprüche, **dadurch gekennzeichnet, dass** das mit den Modifikationen versehene Substrat (2) in einer ersten Ätzlösung behandelt wird, sodass die Konturen (3) entlang der Bearbeitungslinien (4) vollständig getrennt und lediglich durch das insbesondere Chrom als wesentlichen Bestandteil enthaltende Ätzresist (5) mit den angrenzenden Bereichen des Substrats (2) verbunden sind, und dass anschließend in einer weiteren Ätzlösung das Ätzresist (5) entfernt und die von den Bearbeitungslinien (4) eingeschlossenen Bereiche aus dem Substrat (2) herausgetrennt werden.
